# EUROPEAN PATENT APPLICATION

(11) **EP 2 200 417 A2**
(43) Date of publication of application: **23.06.2010**
(21) Application number: 09175386.3
(22) Date of filing: 09.11.2009
(51) Int. Cl.: H05K 9/00

(54) **Installing structure of memory for portable terminal**

(30) Priority: 17.12.2008 KR 20080128534
(71) Applicant: SAMSUNG ELECTRONICS CO., LTD., Suwon-si, Gyeonggi-do (KR)
(72) Inventor: Cha, Kwang-Sik, Gyeonggi-do (KR); Ha, Jung-Su, Gyeonggi-do (KR); Park, Jung-Bae, Daegu (KR)
(74) Representative: Jenkins, Richard Gavin

(57) **Abstract**

An installing structure of a memory for a portable terminal provides easy install and removal. The structure includes a main board and a sub-board coupled to the main board. A chip-type memory is coupled to the sub-board, and an electrical coupling unit transfers electrical signals between the main board and the sub-board. The memory installing structure of the portable terminal provides convenience by facilitating the replacement of the memory for repair or as an upgrade of capacity.

## Description

### BACKGROUND OF THE INVENTION

### 1. Field of the Invention

The present invention relates to the field of memory of a portable terminal. More, particularly, the present invention relates to a structure for installing a detachable memory of a portable terminal.

### 2. Description of the Related Art

Recently, in response to technological advances of the electronic communication industry, portable terminals, such as mobile communication terminals (cellular phones), electronic organizers, and Personal Digital Assistants (PDAs), etc. are intensifying various multimedia functions to meet users' requirements. For example, in such devices a speaker unit for producing melodies of various chords, and/or a color display device with millions of pixels is arranged in some of the new portable terminals. In addition to a fundamental phone call function, the mobile terminal provides a music listening function using a MP3 player and a Digital Multimedia Broadcasting (DMB) function, for receiving not only various game contents but also terrestrial broadcasts using the display device.

State of the art portable terminals are getting increasingly thinner and smaller, despite increased functionality. In this respect, components are added for the various multimedia functions and accordingly, installation spaces for the components are required.

In particular, in order to execute various contents and programs according to the increased user demand, the portable terminal preferably requires a high-capacity internal memory. For example, the internal memory preferably employs a flash memory because flash memory is a non-volatile memory with low power consumption. The flash memory may maintain information stored even without the power turned on, and does not restrict the input and the output of the information. Hence, the flash memory is widely used.

Mostly, flash memories are classified as either of a card type, which is inserted to an external connector of the portable terminal, or a chip type which is surface-mounted to the main board of the portable terminal. Compared with the card-type flash memory, the chip-type flash memory is subject to restrictions in the addition and the replacement of the memory for the sake of the capacity expansion. It also takes some time to alter the artwork and the design of the main board according to the chip to replace and to surface-mount the chip again.

### SUMMARY OF THE INVENTION

Accordingly, the present invention is to provide an installing structure of an internal memory for a portable terminal for restricting temporal and spatial limitations when the internal memory of the portable terminal is replaced.

An exemplary aspect of the present invention is to provide an installing structure of memory for a portable terminal, which can be attached and detached to and from a main board so as to facilitate the replacement of the internal memory coupled to the main board of the portable terminal.

Still another exemplary aspect of the present invention is to provide an installing structure of memory for a portable terminal, which includes a Printed Board Assembly (PBA) including a mounted memory of a certain capacity connectable to a main board of the portable terminal, and a shield that is supported by the main board or a case frame for protecting the PBA.

Other exemplary aspects, advantages, and salient features of the invention will become more apparent to those skilled in the art from the following detailed description, which, taken in conjunction with the annexed drawings, discloses exemplary embodiments of the invention.

In accordance with exemplary aspect of the present invention, an installing structure for memory of a portable terminal is provided. The installing structure of memory for a portable terminal includes a main board, a sub-board to which a chip-type memory is installed, and an electrical coupling unit permits transfer of electrical signals between the main board and the sub-board.

In accordance with another exemplary object of the present invention, a portable terminal comprising an installing structure of memory for a portable terminal. The installing structure of memory for the portable terminal includes a main board, a sub-board to which a chip-type memory is installed, and an electrical coupling unit for transferring electrical signals between the main board and the sub-board.

Other exemplary aspects, advantages and salient features of the invention will become more apparent to those skilled in the art from the following detailed description, which, taken in conjunction with the annexed drawings, discloses exemplary embodiments of the invention in more detail.

### BRIEF DESCRIPTION OF THE DRAWINGS

The above features and advantages of certain exemplary embodiments of the present invention will become more apparent from the following detailed description when taken in conjunction with the accompanying drawings, in which:
FIG. 1 is a perspective view of a portable terminal according to an exemplary embodiment of the present invention;
FIG. 2 is a perspective view of a memory assembly according to an exemplary embodiment of the present invention;
FIG. 3A is a perspective view of the memory assembly and the shield can separated according to an exemplary embodiment of the present invention;
FIG. 3B is a perspective view of the memory assembly and the shield can connected;
FIG. 4A is a perspective view of a memory installing structure separated according to an exemplary embodiment of the present invention; and FIG. 4B is a perspective view of an installing structure of a memory connected according to an exemplary embodiment of the present invention.
FIG. 5 is a partial cross-sectional perspective view of an installing structure of a memory connected according to an exemplary embodiment of the present invention.

Throughout the drawings, like reference numerals will be understood to refer to like parts, components and structures.

### DETAILED DESCRIPTION

The following description, with reference to the accompanying drawings, is provided to assist a person of ordinary skill in the art with a comprehensive understanding of exemplary embodiments of the present invention as defined by the claims. The description includes various specific details to assist in that understanding but these details are to be regarded as merely exemplary. Accordingly, those of ordinary skill in the art will recognize that various changes and modifications of the exemplary embodiments described herein can be made without departing from the scope and spirit of the invention as defined by the appended claims. Also, descriptions of well-known functions and constructions may be omitted for conciseness and so as not to obscure appreciation of the present invention by a person of ordinary skill with such well-known functions and constructions.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention are provided for illustration purpose only and not for the purpose of limiting the invention as defined by the appended claims.

It is to be understood that the singular forms "a", "an", and "the" include plural references unless the context clearly dictates otherwise. Thus, for example, reference to "a component surface" typically includes reference to one or more of such surfaces.

By the term "substantially" typically means that the recited characteristic, parameter, or value need not be achieved exactly, but that deviations or variations, including for example, tolerances, measurement error, measurement accuracy limitations and other factors known to skill in the art, may occur in amounts that do not preclude the effect the characteristic was intended to provide.

Preferred embodiments of the present invention will be described below with reference to the accompanying drawings.

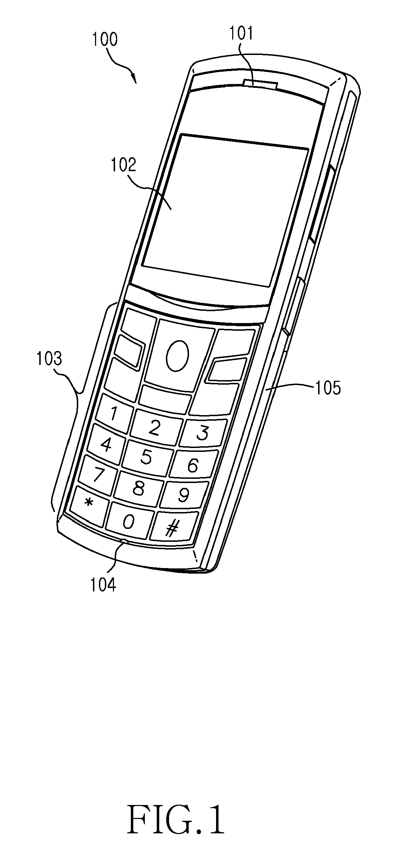

Exemplary embodiments of the present invention provide a memory of a portable terminal. More specifically, the present invention provides a technique relating to an installing structure of a memory for the portable terminal, which can be attached and detached to and from a main board to facilitate replacement of the memory coupled to the main board of the portable terminal.
Herein, the structure of the present invention is applied to, but not limited to, a bar-type wireless portable terminal as shown in FIG. 1. The present invention can be applied to wireless portable terminals of a folder type and a slide type without departing from the scope of the invention. Further, a speaker resonating apparatus of the present invention is applicable to electronic devices using internal memories, such as MP3 player, Portable Media Player (PMP), and camcorder.

FIG. 1 is a perspective view of a portable terminal according to an exemplary embodiment of the present invention.

Referring now to FIG. 1, a portable terminal typically includes a speaker 101 for outputting a voice signal and a display 102 disposed near the speaker 101 to output a video signal. The wireless portable terminal 100 also includes a keypad assembly 103 which is a data input means, and a microphone 104 disposed near the keypad assembly 103 for inputting the voice signal. The display 102 can be a Liquid Crystal Display (LCD) having millions of pixels. In a case where a touch screen is provided to the LCD, the display 102 can function as the data input unit in place of the keypad assembly 103 or as an auxiliary unit.

The portable terminal 100 includes a main board (not shown) mounted in the inside of a case frame 105 which defines an outer surface, and a memory assembly including an installed internal memory connectable to the main board. The memory assembly is secured by the main board, for example, by a metal or a nonmetallic plate (hereafter, referred to as a shield can), or can be affixed to the main board, or the case frame 105, and thus protected against external shock.

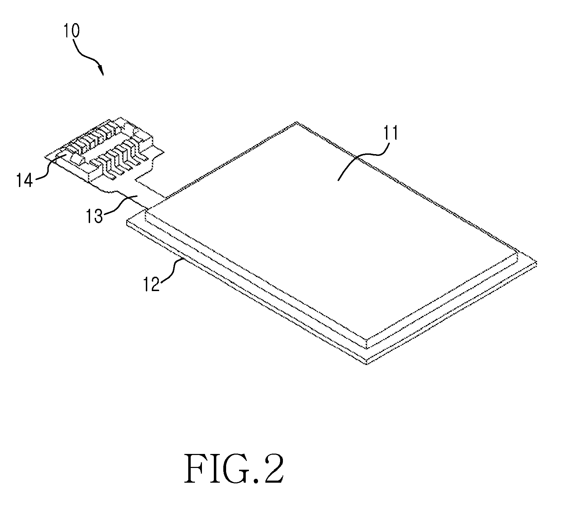

FIG. 2 is a perspective view of the memory assembly according to an exemplary embodiment of the present invention.

Referring now to FIG. 2, the memory assembly includes a chip-type memory 11 of a certain capacity and a Printed Circuit Board (PCB) 12 (hereafter, referred to as a sub-board) on which the memory 11 is preferably surface-mounted. The memory assembly 10 also includes an electrical coupling unit which transfers electrical signals between the sub-board 12 and the main board of the portable terminal, which shall now be described. The electrical coupling unit may include a Flexible Printed Circuit Board (FPCB) 13 with one end electrically coupled to the sub-board 12 to which the memory 10 is installed and the other end includes an FPCB connector 14 socket-connected to the main board of the portable terminal as shown in FIG. 2, which shall be subsequently explained.

The sub-board 12 may include a board-to-board connector structure which can directly interconnect the sub-board 12 and the main board, without the FPCB 13. For example, the sub-board 12 and the main board may include corresponding board connectors surface-mounted respectively. The board connectors may be socket-connected to each other.

In addition to the connector structure as mentioned above, the sub-board 12 and the main board may be electrically coupled by soldering them using the FPCB.

The chip-type memory 11 may comprise, as non-limiting example, a NOR or NAND flash memory. The chip-type memory 11 can be surface-mounted to the sub-board 12 in Quad Flat Package (QFP) or Ball Grid Assembly (BGA) manner according to the packaging.

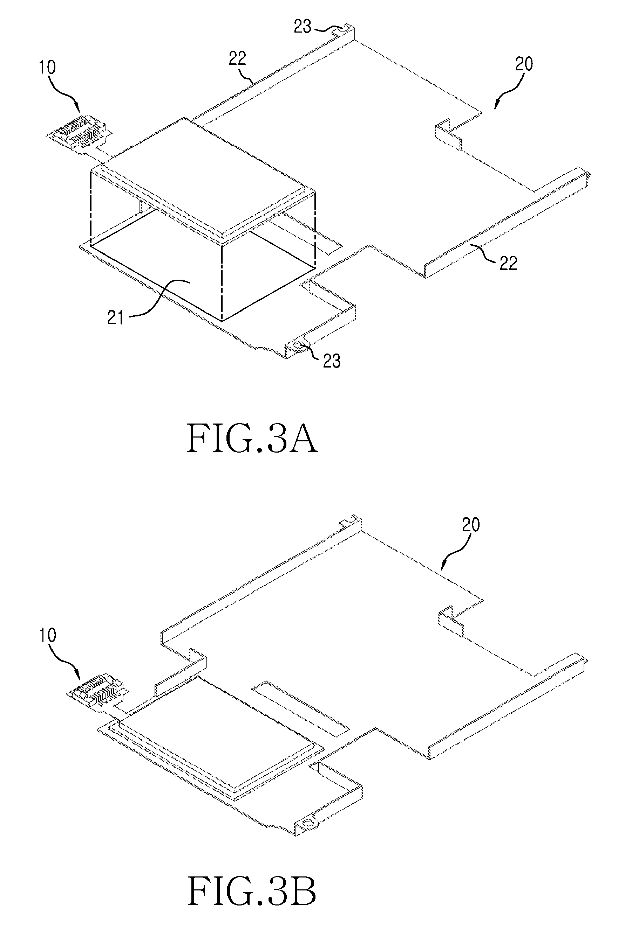

FIG. 3A is a perspective view of the memory assembly and the shield can separated according to an exemplary embodiment of the present invention, and FIG. 3B is a perspective view of the memory assembly and the shield can connected.

Referring now to FIGS. 3A and 3B, the memory assembly 10 such as the example shown in FIG. 2 is attached and secured to the metallic or nonmetallic shield can 20 at a predetermined position. The attaching method may include bonding, adhesives, such as the use of a double tape, or coupling using a fasteners including screw, pins, nails, bolts, snaps, interlocking pieces, etc, just to name a few possibilities. To protect the memory assembly 10 from the outside, an attaching part 21 to which the memory assembly 10 is attached and an external wall 22 of a certain height for enclosing the memory assembly 10 are formed by bending the metallic plate. The shield can 20 may be formed by the plastic injection molding. The shield can 20 may include, for example a plurality of holes 23 formed at one end of the external wall 22 for attaching the shield can 20 to the main board using fasteners. The shield can 20 may be secured to the case frame which forms the exterior of the portable terminal. When the memory assembly 10 and the main board are coupled, a height and a shape of the external wall 22 should be considered to prevent the memory 11 and the components of the main board from interfering with each other.

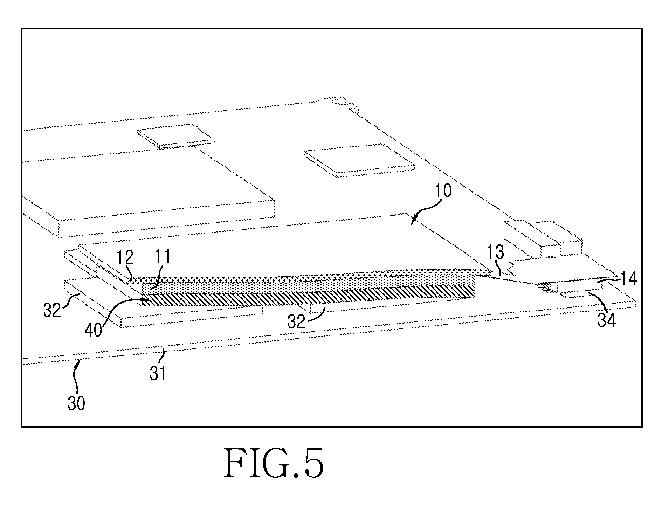

The memory assembly 10 may also be attached and secured to the main board or the case frame without inclusion of the shield can. For example, the memory assembly 10 may be attached onto the chip of the main board by means of a certain buffer. A more detailed structure of an installing structure will be described below with reference to FIG. 5.

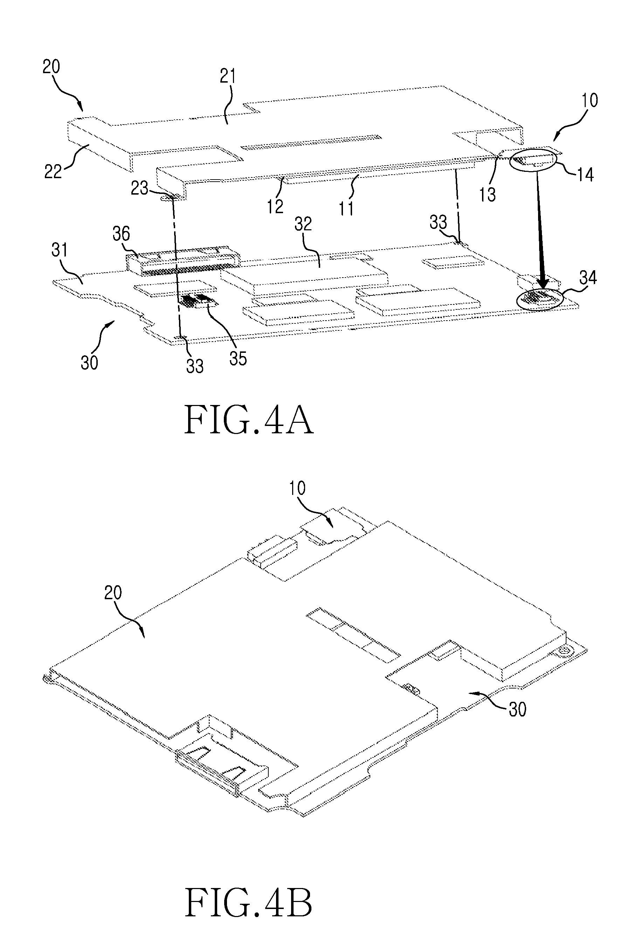

FIG. 4A is a perspective view of a memory installing structure according to another exemplary embodiment of the present invention ,and FIG. 4B is a perspective view of the memory installing structure connected according to an exemplary embodiment of the present invention.

Referring now to FIGS. 4A and 4B, the shield can 20, where the memory assembly 10 is attached in this example as previously described and shown in FIGS. 2 through 3B, is coupled with the main board 30 of the portable terminal. The main board 30 of the portable terminal may include, for example, a PCB 31, a plurality of chips 32 typically surface-mounted onto the PCB 31, a plurality of board connectors 35, a plurality of external connectors 36 exposed to the case frame for connecting with external devices, and a plurality of various types of components (not shown). At least one of the chips 32 may be an embedded memory. The main board 30 may be coupled with an external memory using any one of the external connectors 36. In particular, the main board 30 includes a board connector 34 corresponding to the FPCB connector 14 of the memory assembly 10. The main board 30 includes holes 33 corresponding to the holes 23 of the shield can 20.

One skilled in the art should understand and appreciate that the FPCB connector 14 of the memory assembly 10 socket-connected to the main board 30 can be disconnected and then the shield can 20 including the attached memory assembly 10 can be separated from the main board 30. Next, one skilled in the art should also understand and appreciate the memory assembly 10 may be detached from the shield can 20 and replaced with a new memory assembly. By reversing the above exemplary processes, the memory assembly can be re-attached.

The main board 30 and the sub-board 12 may be coupled by soldering via a FPCB as stated above. In this particular case, one skilled in the art may detach the sub-board 12 from the main board 30 by removing the solder from either end. Also, one skilled in the art may replace with a sub-board, including a new memory, by re-soldering.

FIG. 5 is a partial cross-sectional perspective view of an installing structure of a memory connected according to an exemplary embodiment of the present invention.

Referring to FIG. 5, the memory assembly 10 may also be attached and secured to the main board or the case frame without inclusion of the shield can. For example, the memory assembly 10 may be attached onto the chip of the main board by means of a buffer 40, such as a non-conductible sponge, a non-conductible plate, and the like.

As set forth above, the memory installing structure of the portable terminal provides the convenience of easy replacement of the memory of the corresponding capacity to change.

While the invention has been shown and described with reference to certain exemplary embodiments thereof, it will be understood by those skilled in the art that various changes in form and details may be made therein without departing from the spirit and scope of the invention as defined by the appended claims and their equivalents. Therefore, the scope of the invention is defined not by the detailed description of the invention but by the appended claims, and all differences within the scope will be construed as being included in the present invention.

## Claims

1. A memory installing structure of a portable terminal comprising:
a main board (30);
a sub-board (12);
a chip-type memory (11) coupled to the sub-board (12); and
an electrical coupling means (13) for transferring electrical signals between the main board (30) and the sub-board (12).

2. The memory installing structure of claim 1, further comprising:
a metallic or nonmetallic shield (20) for affixing or protecting the sub-board (12), said shield (20) being secured to the main board (30) or to a case frame (105) that defines an outer surface of the portable terminal.

3. The memory installing structure of claim 1, wherein the sub-board (12) is attached by a buffer to at least one of the main board (30) or to a case frame (105) that defines an outer surface of the portable terminal.

4. The memory installing structure of claim 1, wherein the electrical coupling means (13) comprises board connectors (35) arranged on the sub-board (12) and the main board (30), respectively, for directly socket-connecting the sub-board and the main board to each other.

5. The memory installing structure of claim 1, wherein the electrical coupling means (13) is detachable to and from the sub-board (12) or the main board (30).

6. The memory installing structure of claim 1, wherein the electrical coupling means (13) comprises a Flexible Printed Circuit Board (FPCB) having a first end electrically coupled to the sub-board (12) and a second end electrically coupled to the main board (30).

7. The memory installing structure of claim 1, wherein the electrical coupling means (13) comprises:
board connectors (34) provided to the sub-board (12) and the main board (30); and
a Flexible Printed Circuit Board (FPCB) comprising FPCB connectors (14) at two ends for electrically coupling to the board connectors (34).

8. The memory installing structure of claim 1, wherein the electrical coupling means (13) comprises:
one or more board connectors (34) arranged on the main board (30); and
a Flexible Printed Circuit Board (FPCB) with a first end electrically coupled to the sub-board (12) and a second end comprising an FPCB connector (14) electrically coupled to said one or more board connectors (34) of the main board.

9. The memory installing structure of claim 1, wherein the electrical coupling means comprises a Flexible Printed Circuit Board (FPCB) having two ends soldered to the sub-board (12) and the main board (30) , respectively.

10. The memory installing structure of claim 1, wherein the memory comprises a flash memory.

11. The memory installing structure of claim 1, wherein the memory is surface-mounted in a Ball Grid Assembly (BGA) arrangement.

12. A portable terminal comprising a memory installing structure, wherein the memory installing structure comprises:
a main board (30);
a sub-board (12) coupled to the main board;
a chip-type memory (11) coupled to the sub-board (12); and
an electrical coupling means (13), said electrical coupling means being detachable, for transferring electrical signals between the main board (30) and the sub-board (12).

13. The memory installing structure of claim 12, further comprising:
a shield (20) for affixing or protecting the sub-board (12) , said shield (20)being secured to at least one of the main board (30) or to a case frame (105) that defines an outer surface of the portable terminal.

14. The memory installing structure of claim 12, wherein the sub-board (12) is attached by a buffer to at least one of the main board (30)or a case frame (105) that defines an outer surface of the portable terminal.

15. The memory installing structure of claim 13, wherein the electrical coupling means (13) comprises a Flexible Printed Circuit Board (FPCB) with a first end electrically coupled to the sub-board (12) and a second end electrically coupled to the main board (30).
